# EUROPEAN PATENT APPLICATION

(11) **EP 2 475 011 A2**
(43) Date of publication of application: **11.07.2012**
(21) Application number: 11009924.9
(22) Date of filing: 16.12.2011
(51) Int. Cl.: H01L 31/02, H01L 31/05

(54) **Photovoltaic power generating module and photovoltaic power generating system**

(30) Priority: 07.01.2011 JP 2011001953
(71) Applicant: Sony Corporation, Tokyo 108-0075 (JP)
(72) Inventor: Hasegawa, Hiroshi, Tokyo 108-0075 (JP)
(74) Representative: Müller - Hoffmann & Partner

(57) **Abstract**

Disclosed herein is a photovoltaic power generating module including a cell, a plurality of cell groups, and a plurality of bypass sections. The cell is configured to generate power according to light received by the cell. The plurality of cell groups are formed by connecting a predetermined number of the cells in series with each other. The bypass sections are configured to bypass the respective the cell groups connected in series with each other. The cell groups are formed by respective different numbers of the cells.

## Description

### BACKGROUND

The present disclosure relates to a photovoltaic power generating module and a photovoltaic power generating system, and particularly to a photovoltaic power generating module and a photovoltaic power generating system that make it possible to identify a bypassed cell easily by merely measuring a total voltage.

A photovoltaic power generating system is generally formed by connecting a plurality of photovoltaic power generating modules in series with each other, the photovoltaic power generating modules being formed by electrically connecting a plurality of cells (solar cell elements) for receiving sunlight and generating power in series with each other. Thus, when the sunlight is blocked by a cloud, a structure, or the like and a part of a module is thereby shaded, a current is interrupted by a cell not generating power due to an effect of the partial shadow, so that the output of the module as a whole is decreased. As a result, a total amount of power generated by the photovoltaic power generating system is decreased.

Accordingly, a photovoltaic power generating system in the past has a bypass diode provided for each module in order to prevent a decrease in total amount of power generated.

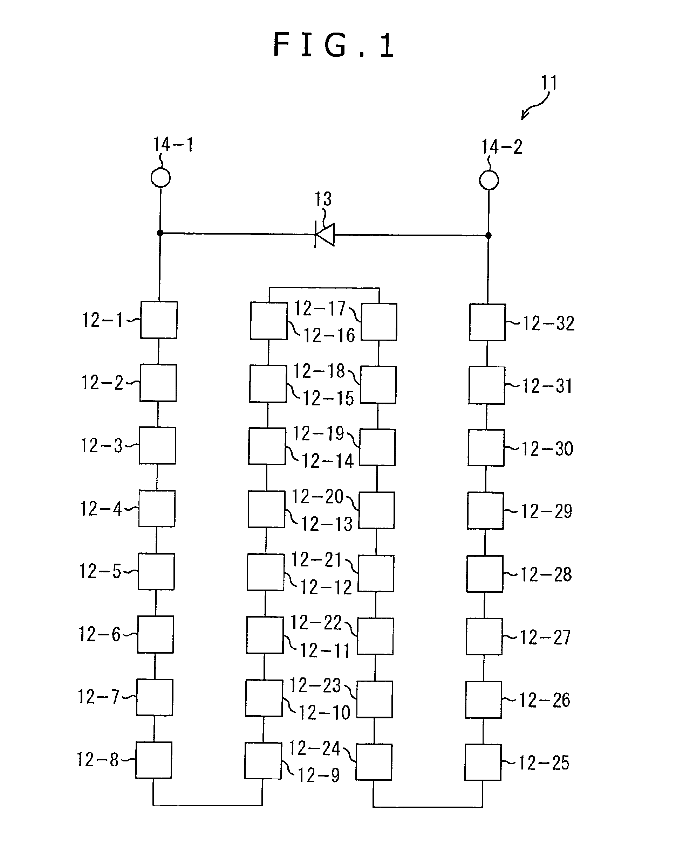

For example, a module 11 shown in FIG. 1 is formed by connecting 32 cells 12-1 to 12-32 in series with each other and providing a bypass diode 13 in such a manner as to connect terminals 14-1 and 14-2 at both ends of the cells 12-1 to 12-32 to each other.

Because the bypass diode 13 is thus provided, when the output of the module 11 is decreased due to an effect of a partial shadow, a current flows through the bypass diode 13, and the module 11 is bypassed by the bypass diode 13. Thereby, a decrease in total amount of power generated by a photovoltaic power generating system formed by connecting a plurality of modules 11 in series with each other is prevented. That is, there occurs a decrease only in amount of power generated by one module 11. In addition, when a failure occurs in at least one of cells 12 within a module 11, the module 11 is bypassed by the bypass diode 13, whereby a decrease in total amount of power generated by the photovoltaic power generating system is prevented.

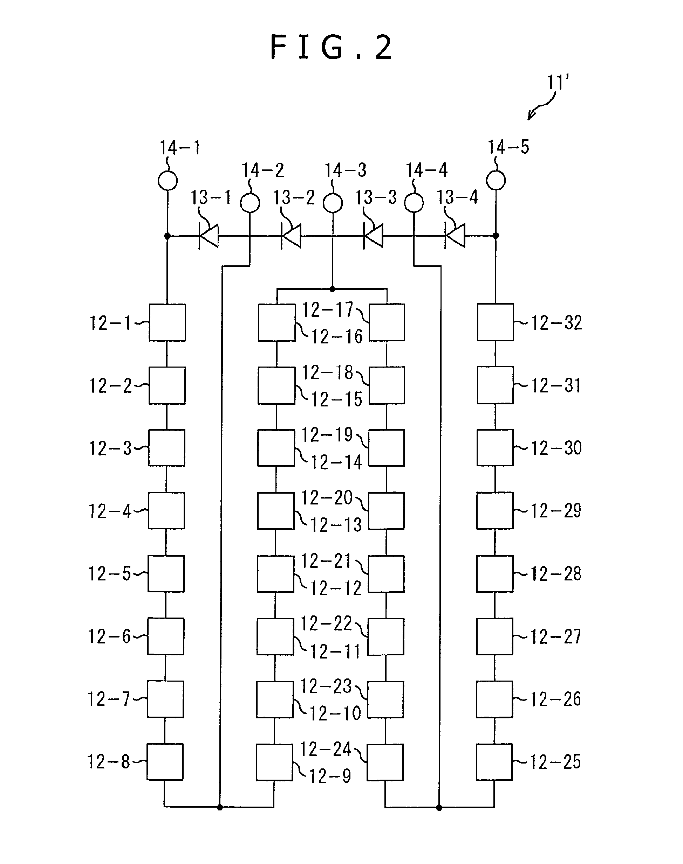

In addition, for example, a module 11 may be formed so as to have a plurality of bypass diodes 13. FIG. 2 shows a module 11' including 32 cells 12-1 to 12-32 and four bypass diodes 13-1 to 13-4.

The cells 12-1 to 12-32 are connected in series with each other. The bypass diode 13-1 connects terminals 14-1 and 14-2 at both ends of the cells 12-1 to 12-8 to each other. The bypass diode 13-2 connects terminals 14-2 and 14-3 at both ends of the cells 12-9 to 12-16 to each other. The bypass diode 13-3 connects terminals 14-3 and 14-4 at both ends of the cells 12-17 to 12-24 to each other. The bypass diode 13-4 connects terminals 14-4 and 14-5 at both ends of the cells 12-25 to 12-32 to each other.

Thus, in the module 11', respective groups of the cells 12-1 to 12-8, the cells 12-9 to 12-16, the cells 12-17 to 12-24, and the cells 12-25 to 12-32 are bypassed by the first to fourth bypass diodes 13-1 to 13-4. Therefore, when a malfunction has occurred in one of the cells 12, only a group including the cell 12 in which the malfunction has occurred among the respective groups of the cells 12-1 to 12-8, the cells 12-9 to 12-16, the cells 12-17 to 12-24, and the cells 12-25 to 12-32 is bypassed. Thereby, a decrease in output of the module 11' as a whole is avoided.

In the module 11', when one of the respective groups of the cells 12-1 to 12-8, the cells 12-9 to 12-16, the cells 12-17 to 12-24, and the cells 12-25 to 12-32 is bypassed, the bypassed group of cells 12 (cell group composed of eight cells 12) cannot be identified by merely checking the voltage of the module 11' as a whole (voltage between the terminals 14-1 and 14-5 at both ends).

Japanese Patent Laid-Open No. Hei 8-97456, for example, discloses a solar cell power generating device using light emitting diodes to thereby make it possible to find a bypassed solar cell panel. However, in a system at a high elevation such as a rooftop, a wall surface of a building, or the like or on a large scale, it is not easy to check that the light emitting diodes are lit, and it is thus difficult to find a bypassed solar cell panel.

### SUMMARY

As described above, it has been difficult to identify a bypassed cell (or a cell group composed of a plurality of cells) by merely measuring the voltage of a module as a whole. In addition, when a plurality of bypass diodes are provided, cost is correspondingly increased. There is thus a desire to add not only a function of suppressing a decrease in output but also a new function.

The present technology has been made in view of such a situation, and it is desirable to be able to provide a new function enabling a bypassed cell to be easily identified by merely measuring a total voltage.

Various respective aspects and features of the invention are defined in the appended claims.

According to a first embodiment of the present technology, there is provided a photovoltaic power generating module including:
a cell configured to generate power according to light received by the cell;
a plurality of cell groups formed by connecting a predetermined number of the cells in series with each other; and
a plurality of bypass sections configured to bypass the respective the cell groups connected in series with each other;
wherein the cell groups are formed by respective different numbers of the cells.

According to a second embodiment of the present technology, there is provided a photovoltaic power generating system including:
a cell configured to generate power according to light received by the cell;
a plurality of photovoltaic power generating modules formed by connecting a predetermined number of the cells in series with each other; and
a plurality of bypass sections configured to bypass the respective the photovoltaic power generating modules connected in series with each other;
wherein the photovoltaic power generating modules have respective different numbers of the cells.

According to the first and second embodiments of the present technology, it is possible to identify a bypassed cell easily by merely measuring a total voltage.

### BRIEF DESCRIPTION OF THE DRAWINGS

FIG. 1 is a diagram showing an example of a module used in a photovoltaic power generating system in the past;
FIG. 2 is a diagram showing an example of a module including a plurality of bypass diodes;
FIG. 3 is a diagram showing a configuration example according to an embodiment of a module used in a photovoltaic power generating system to which the present technology is applied;
FIG. 4 is a diagram showing relations between bypassed cell groups and decreases in output voltage;
FIG. 5 is a diagram showing an example of a module having cells arranged in the form of a rectangle;
FIG. 6 is a block diagram showing a configuration example according to a first embodiment of the photovoltaic power generating system;
FIG. 7 is a diagram showing relations between bypassed cell groups and decreases in output voltage;
FIG. 8 is a block diagram showing a configuration example according to a second embodiment of the photovoltaic power generating system;
FIG. 9 is a diagram showing relations between bypassed modules and decreases in output voltage;
FIG. 10 is a block diagram showing a configuration example according to a third embodiment of the photovoltaic power generating system;
FIG. 11 is a diagram showing numbers of cells bypassed;
FIG. 12 is a diagram showing relations between bypassed cell groups and decreases in output voltage;
FIG. 13 is a block diagram showing a configuration example according to a fourth embodiment of the photovoltaic power generating system;
FIG. 14 is a diagram showing the power generation characteristics of a module;
FIG. 15 is a diagram showing a modification example of a module; and
FIG. 16 is a diagram showing a modification example of the photovoltaic power generating system.

### DETAILED DESCRIPTION OF THE PREFERRED EMBODIMENTS

Concrete embodiments of the present technology will hereinafter be described in detail with reference to the drawings.

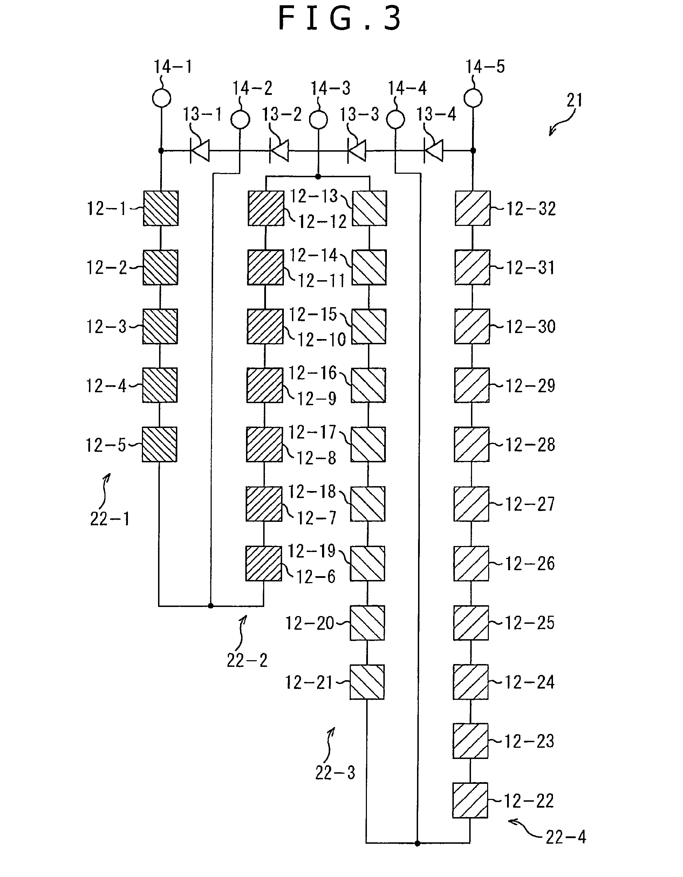

FIG. 3 is a diagram showing a configuration example according to an embodiment of a module used in a photovoltaic power generating system to which the present technology is applied.

The module 21 in FIG. 3 includes cells 12-1 to 12-32 and a first to a fourth bypass diode 13-1 to 13-4.

The cells 12-1 to 12-32 are connected in series with each other. In addition, the cells 12-1 to 12-32 each generate power by receiving sunlight. The power generated in the cells 12-1 to 12-32 is output from terminals 14-1 and 14-5 of both ends of the module 21.

The first bypass diode 13-1 is connected between terminals 14-1 and 14-2 of both ends of the cells 12-1 to 12-5. When a malfunction occurs in one of the cells 12-1 to 12-5, the first bypass diode 13-1 bypasses the cells 12-1 to 12-5. The cells 12-1 to 12-5 bypassed by the first bypass diode 13-1 will hereinafter be referred to as a first cell group 22-1.

The second bypass diode 13-2 is connected between terminals 14-2 and 14-3 of both ends of the cells 12-6 to 12-12. When a malfunction occurs in one of the cells 12-6 to 12-12, the second bypass diode 13-2 bypasses the cells 12-6 to 12-12. The cells 12-6 to 12-12 bypassed by the second bypass diode 13-2 will hereinafter be referred to as a second cell group 22-2.

The third bypass diode 13-3 is connected between terminals 14-3 and 14-4 of both ends of the cells 12-13 to 12-21. When a malfunction occurs in one of the cells 12-13 to 12-21, the third bypass diode 13-3 bypasses the cells 12-13 to 12-21. The cells 12-13 to 12-21 bypassed by the third bypass diode 13-3 will hereinafter be referred to as a third cell group 22-3.

The fourth bypass diode 13-4 is connected between terminals 14-4 and 14-5 of both ends of the cells 12-22 to 12-32. When a malfunction occurs in one of the cells 12-22 to 12-32, the fourth bypass diode 13-4 bypasses the cells 12-22 to 12-32. The cells 12-22 to 12-32 bypassed by the fourth bypass diode 13-4 will hereinafter be referred to as a fourth cell group 22-4.

Thus, in the module 21, the cells 12-1 to 12-32 are divided into the first to fourth cell groups 22-1 to 22-4 by the first to fourth bypass diodes 13-1 to 13-4. Incidentally, hereinafter, when each of the cells 12-1 to 12-32 does not need to be distinguished from the other, the cells 12-1 to 12-32 will be referred to as a cell 12 as appropriate.

In the module 21, when a malfunction occurs in a cell 12 of one of the first to fourth cell groups 22-1 to 22-4, for example when a part of the cells 12 are not irradiated with sunlight due to a partial shadow on the module 21, or when a failure (abnormality) occurs in one of the cells 12, one of the first to fourth cell groups 22-1 to 22-4 including the cell 12 causing the malfunction is bypassed by the corresponding one of the first to fourth bypass diodes 13-1 to 13-4.

Whereas the cells 12-1 to 12-32 are divided into four equal parts including an identical number of cells (eight) in the module 11' in FIG. 2, the cells 12-1 to 12-32 in the module 21 are divided into four parts including different numbers of cells. Specifically, the cells 12-1 to 12-32 in the module 21 are divided into the four parts that are the first cell group 22-1 composed of five cells 12-1 to 12-5, the second cell group 22-2 composed of seven cells 12-6 to 12-12, the third cell group 22-3 composed of nine cells 12-13 to 12-21, and the fourth cell group 22-4 composed of eleven cells 12-22 to 12-32.

Thus, in the module 21, potential differences across the respective first to fourth cell groups 22-1 to 22-4 are different values. Therefore, in the module 21, when one of the first to fourth cell groups 22-1 to 22-4 is bypassed, the bypassed one of the first to fourth cell groups 22-1 to 22-4 can be identified by checking the output voltage of the module 21 as a whole (potential difference between the terminals 14-1 and 14-5).

That is, when a malfunction occurs in one of the cells 12, and one of the first to fourth cell groups 22-1 to 22-4 is bypassed, the output voltage is decreased by a value differing according to the one of the first to fourth cell groups 22-1 to 22-4. Thus, the bypassed one of the first to fourth cell groups 22-1 to 22-4 can be identified by measuring the decrease in the output voltage of the module 21 as a whole. It is thereby possible to identify the cell 12 causing the malfunction to a certain extent, that is, identify which of the first to fourth cell groups 22-1 to 22-4 includes the cell 12.

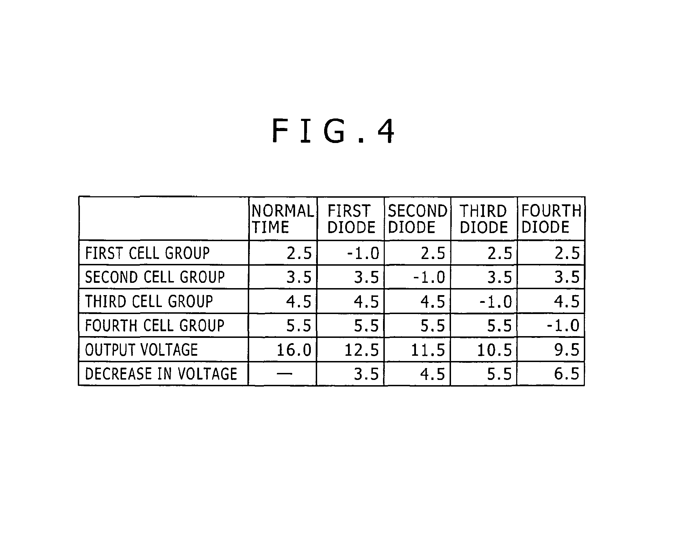

Referring FIG. 4, description will be made of decreases in the output voltage when the first to fourth cell groups 22-1 to 22-4 are bypassed by the corresponding first to fourth bypass diodes 13-1 to 13-4, respectively.

FIG. 4 shows an example of the output voltage when the voltage generated by one cell 12 is 0.5 V and when the voltage in a forward direction of the first to fourth bypass diodes 13-1 to 13-4 is 1.0 V.

When all of the cells 12-1 to 12-32 generate power normally, a potential difference between the cells 12-1 to 12-32, that is, the output voltage of the module 21 is 16.0 V. At this time, the potential difference of the first cell group 22-1 is 2.5 V, the potential difference of the second cell group 22-2 is 3.5 V, the potential difference of the third cell group 22-3 is 4.5 V, and the potential difference of the fourth cell group 22-4 is 5.5 V.

When a malfunction occurs in one of the cells 12-1 to 12-5, and the first bypass diode 13-1 is turned on to bypass the first cell group 22-1, the potential difference of the first cell group 22-1 becomes 1.0 V. Thus, the output voltage of the module 21 in this case becomes 12.5 V, and the output voltage is decreased by 3.5 V from the time of the normal power generation.

When a malfunction occurs in one of the cells 12-6 to 12-12, and the second bypass diode 13-2 is turned on to bypass the second cell group 22-2, the potential difference of the second cell group 22-2 becomes 1.0 V. Thus, the output voltage of the module 21 in this case becomes 11.5 V, and the output voltage is decreased by 4.5 V from the time of the normal power generation.

Similarly, when a malfunction occurs in one of the cells 12-13 to 12-21, and the third bypass diode 13-3 is turned on to bypass the third cell group 22-3, the output voltage of the module 21 becomes 10.5 V, and the output voltage is decreased by 5.5 V from the normal time. When a malfunction occurs in one of the cells 12-22 to 12-32, and the fourth bypass diode 13-4 is turned on to bypass the fourth cell group 22-4, the output voltage of the module 21 becomes 9.5 V, and the output voltage is decreased by 6.5 V from the normal time.

By thus checking the output voltage of the module 21 and referring to the relations of the decreases in the output voltage as shown in FIG. 4, it is possible to identify which of the first to fourth cell groups 22-1 to 22-4 is bypassed. Specifically, when the output voltage of the module 21 is 12.5 V, the output voltage is decreased by 3.5 V from the time of the normal power generation, and it is thereby determined that the bypass diode 13-1 is on and that the first cell group 22-1 is bypassed.

In this case, a user can recognize that a malfunction has occurred in one of the cells 12-1 to 12-5 included in the first cell group 22-1. The user can further determine whether the malfunction has occurred in the cells 12-1 to 12-5 due to an effect of a partial shadow by visually checking the module 21. Alternatively, when there is no shadow on the cells 12, the user can determine whether a failure has occurred in the cells 12 without an effect of a shadow by checking the output voltage of the module 21.

In addition, a bypassed cell group 22 can be identified automatically by providing a measuring device including a measuring section for measuring the output voltage of the module 21 and a storage section for storing the relations in FIG. 4, periodically measuring the output voltage of the module 21, and accumulating data obtained by the measurement.

As described above, the module 21 enables a bypassed one of the first to fourth cell groups 22-1 to 22-4 to be identified by checking the output voltage of the module 21. Thereby, a cell 12 in which a malfunction has occurred can be identified from among the cells 12-1 to 12-32 to a certain extent.

In addition, the cells 12-1 to 12-32 in the module 21 are divided into four parts by the first to fourth bypass diodes 13-1 to 13-4. Thus, even when the output of a part of the cells 12 is decreased due to an effect of a partial shadow, only an amount of power generated by the cell group 22 including that cell 12 is decreased, and power generated by the other cell groups 22 is output. That is, the module 21 as a whole can avoid a decrease in output. Even when the provision of the plurality of bypass diodes increases cost, a new function of being able to identify a bypassed one of the first to fourth cell groups 22-1 to 22-4 can be provided to the module 21. That is, the module 21 obtains a new effect commensurate with an increase in cost.

Incidentally, while the module 21 of FIG. 3 is a configuration example having four cell groups 22, there may be four cell groups 22 or less or four cell groups 22 or more.

In addition, the number of cells 12 possessed by each of the cell groups 22 is not limited to the numbers shown in FIG. 3. It suffices for the cell groups 22 to have at least one cell 12 and for each of the cell groups 22 to have a different number of cells 12.

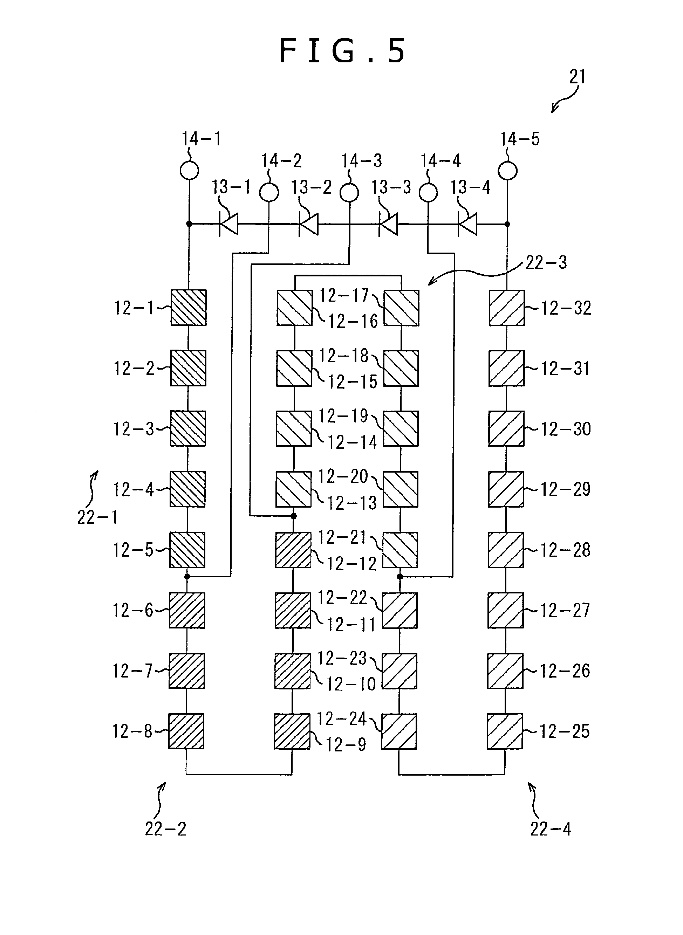

In addition, the arrangement of the cells 12-1 to 12-32 is not limited to the example shown in FIG. 3. For example, as shown in FIG. 5, the cells 12-1 to 12-32 can be arranged so as to form an eight-by-four array, so that the module 21 can be formed in a rectangular shape.

A photovoltaic power generating system is generally formed by connecting a plurality of modules 21 in series with each other to obtain a power of increased voltage efficient for conversion into commercial voltage.

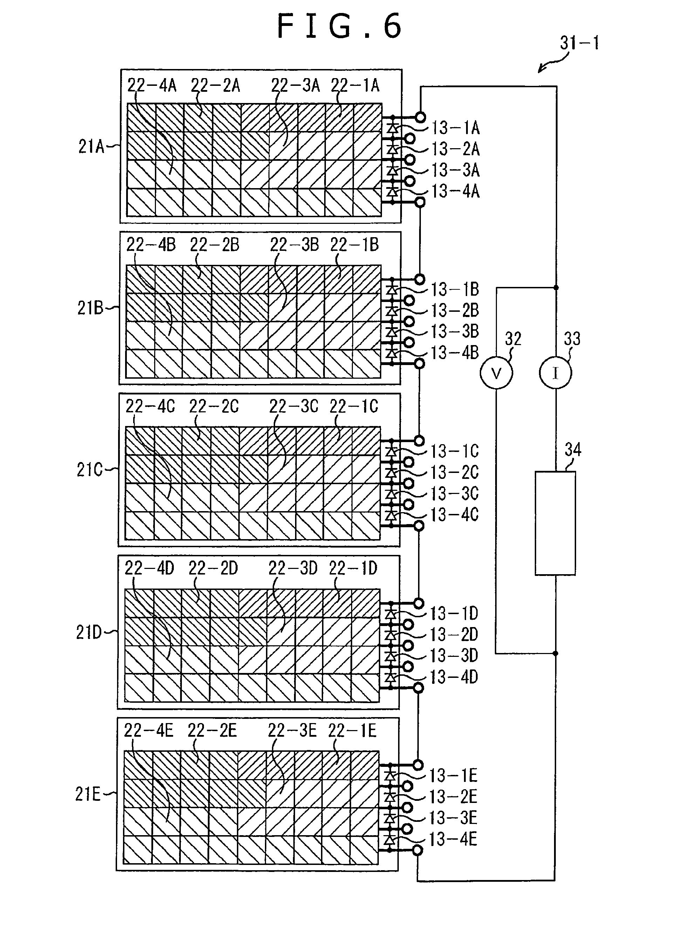

Next, FIG. 6 is a block diagram showing a configuration example of a first embodiment of a photovoltaic power generating system including a plurality of modules 21.

As shown in FIG. 6, the photovoltaic power generating system 31-1 includes a first to a fifth module 21A to 21E, a voltage measuring section 32, a current measuring section 33, and a load 34.

The photovoltaic power generating system 31-1 is formed by connecting the first to fifth modules 21A to 21E in series with each other. In addition, the first to fifth modules 21A to 21E are each formed by connecting 36 cells 12 in series with each other, as described with reference to FIG. 3.

Specifically, in the first module 21A, 36 cells 12 are divided into a first to a fourth cell group 22-1A to 22-4A by a first to a fourth bypass diode 13-1A to 13-4A. In addition, in the second module 21B, 36 cells 12 are divided into a first to a fourth cell group 22-1B to 22-4B by a first to a fourth bypass diode 13-1B to 13-4B.

Similarly, in the third module 21C, 36 cells 12 are divided into a first to a fourth cell group 22-1C to 22-4C by a first to a fourth bypass diode 13-1C to 13-4C. In addition, in the fourth module 21D, 36 cells 12 are divided into a first to a fourth cell group 22-1D to 22-4D by a first to a fourth bypass diode 13-1D to 13-4D. In the fifth module 21E, 36 cells 12 are divided into a first to a fourth cell group 22-1E to 22-4E by a first to a fourth bypass diode 13-1E to 13-4E.

The voltage measuring section 32 measures an output voltage output from the whole of the first to fifth modules 21A to 21E connected in series with each other. The current measuring section 33 measures the current of power generated by the first to fifth modules 21A to 21E. The load 34 is various devices that consume the power generated by the first to fifth modules 21A to 21E.

In the thus configured photovoltaic power generating system 31-1, a cell 12 in which a malfunction has occurred can be identified to a certain extent by checking the output voltage of the whole of the first to fifth modules 21A to 21E.

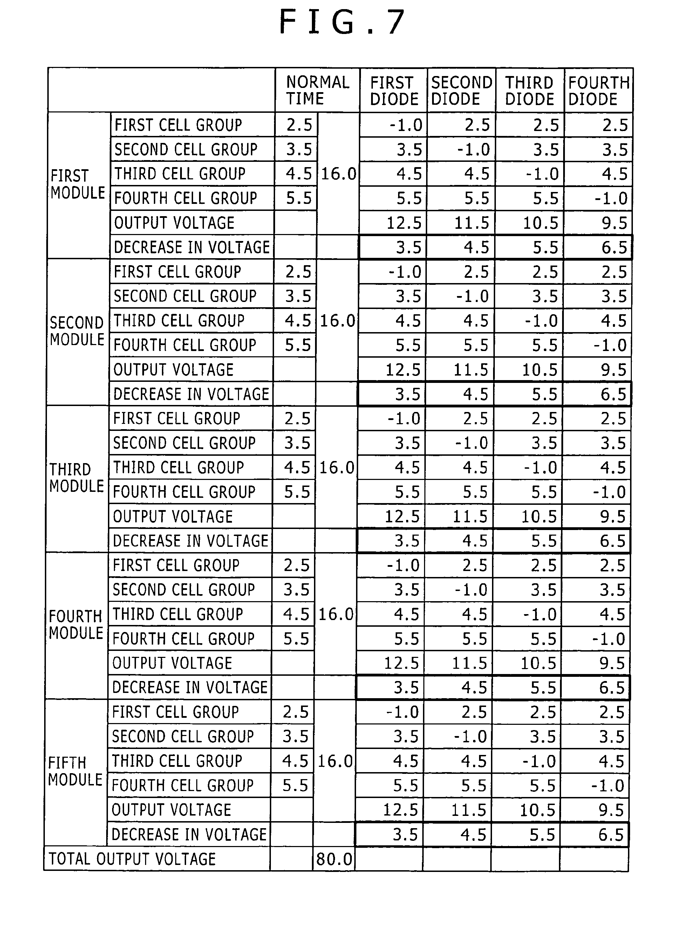

Decreases in the output voltage when a malfunction occurs in cells 12 will be described with reference to FIG. 7.

FIG. 7 shows an example of the output voltage when the voltage generated by one cell 12 is 0.5 V and when the voltage in a forward direction of the first to fourth bypass diodes 13-1A to 13-4E is 1.0 V.

When all of the cells 12 possessed by the photovoltaic power generating system 31-1 generate power normally, the output voltages of the first to fifth modules 21A to 21E are each 16.0 V. Then, the output voltage of the first to fifth modules 21A to 21E as a whole, that is, the output voltage of the photovoltaic power generating system 31-1 as a whole is 80.0 V.

In addition, as described with reference to FIG. 4, as for the first module 21A, the potential difference of the first cell group 22-1A is 2.5 V, the potential difference of the second cell group 22-2A is 3.5 V, the potential difference of the third cell group 22-3A is 4.5 V, and the potential difference of the fourth cell group 22-4A is 5.5 V. Thus, when the first cell group 22-1A is bypassed by the first bypass diode 13-1A, the output voltage of the first module 21A becomes 12.5 V, and the output voltage is decreased by 3.5 V from the normal time. Similarly, the output voltage is decreased by 4.5 V when the second cell group 22-2A is bypassed, the output voltage is decreased by 5.5 V when the third cell group 22-3A is bypassed, and the output voltage is decreased by 6.5 V when the fourth cell group 22-4A is bypassed.

The output voltages of the second to fifth modules 21B to 21E are also decreased in a similar manner to that of the first module 21A.

Thus, when the output voltage of the photovoltaic power generating system 31-1 as a whole is decreased by 3.5 V from 80.0 V, it is determined that one of the first bypass diodes 13-1A, 13-1B, 13-1C, 13-1D, and 13-1E is on, and that one of the first cell groups 22-1A, 22-1B, 22-1C, 22-1D, and 22-1E is bypassed. Thereby, it can be determined that one of the first cell groups 22-1A, 22-1B, 22-1C, 22-1D, and 22-1E includes a cell 12 in which a malfunction has occurred.

Similarly, when the output voltage of the photovoltaic power generating system 31-1 as a whole is decreased by 4.5 V from 80.0 V, it is determined that one of the second cell groups 22-2A, 22-2B, 22-2C, 22-2D, and 22-2E is bypassed. In addition, when the output voltage of the photovoltaic power generating system 31-1 as a whole is decreased by 5.5 V from 80.0 V, it is determined that one of the third cell groups 22-3A, 22-3B, 22-3C, 22-3D, and 22-3E is bypassed. In addition, when the output voltage of the photovoltaic power generating system 31-1 as a whole is decreased by 6.5 V from 80.0 V, it is determined that one of the fourth cell groups 22-4A, 22-4B, 22-4C, 22-4D, and 22-4E is bypassed.

By thus checking the output voltage of the photovoltaic power generating system 31-1 as a whole and referring to the relations of the decreases in the output voltage as shown in FIG. 7, it is possible to identify a bypassed cell group 22. Thereby, the cell group 22 including a cell 12 in which a malfunction has occurred can be identified to a certain extent.

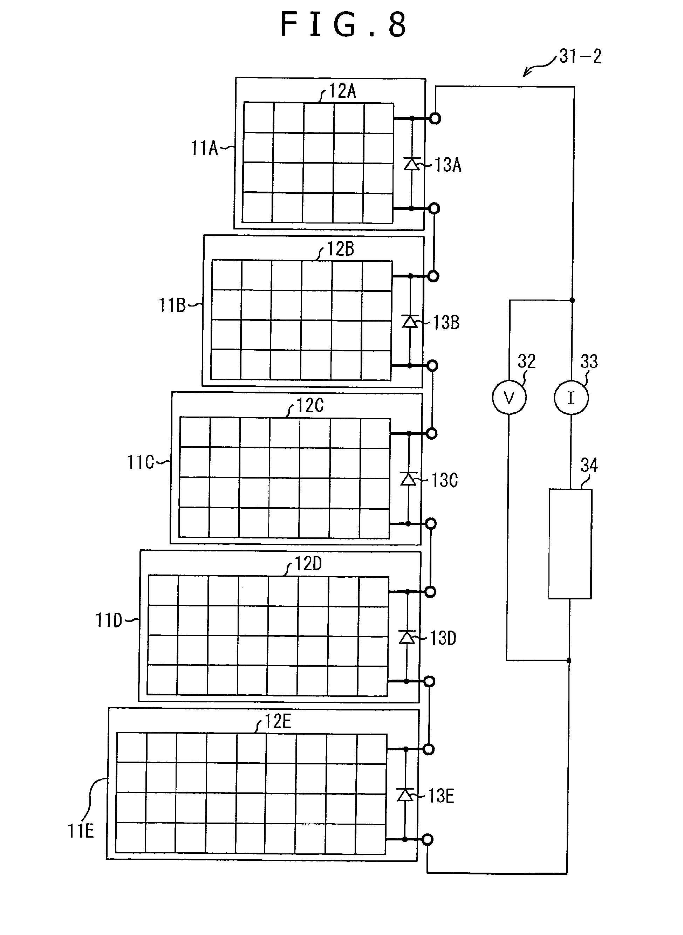

Next, FIG. 8 is a block diagram showing a configuration example of a second embodiment of the photovoltaic power generating system.

As shown in FIG. 8, the photovoltaic power generating system 31-2 includes a first to a fifth module 11A to 11E, a voltage measuring section 32, a current measuring section 33, and a load 34. Incidentally, the voltage measuring section 32, the current measuring section 33, and the load 34 are formed in a same manner as in the photovoltaic power generating system 31-1 of FIG. 6, and therefore detailed description thereof will be omitted.

In the photovoltaic power generating system 31-2, the first to fifth modules 11A to 11E are connected in series with each other.

As with the module 11 in FIG. 1, the first to fifth modules 11A to 11E are formed by connecting a plurality of cells 12 in series with each other, and providing a first to a fifth bypass diode 13A to 13E in such a manner as to connect both ends of these cells 12 to each other. In addition, the first to fifth modules 11A to 11E have respective different numbers of cells 12.

For example, the first module 11A is formed by connecting 20 cells 12A in series with each other and providing the first bypass diode 13A in such a manner as to connect both ends of these cells 12A to each other. In addition, the second module 11B is formed by connecting 24 cells 12B in series with each other and providing the second bypass diode 13B in such a manner as to connect both ends of these cells 12B to each other. The third module 11C is similarly formed with 28 cells 12C. The fourth module 11D is similarly formed with 32 cells 12D. The fifth module 11E is similarly formed with 36 cells 12E.

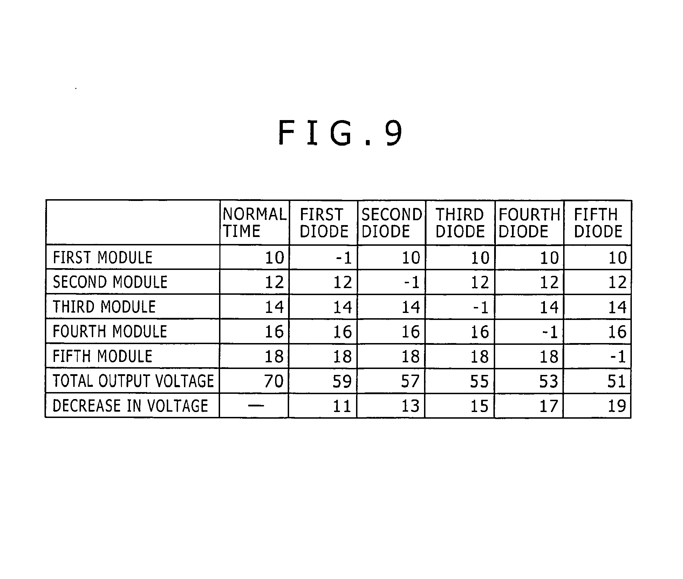

FIG. 9 shows an example of the output voltage of the photovoltaic power generating system 31-2 when the voltage generated by one cell 12 is 0.5 V and the voltage in a forward direction of the first to fifth bypass diodes 13A to 13E is 1.0 V.

When all of the first to fifth modules 11A to 11E generate power normally, the output voltage of the first to fifth modules 11A to 11E as a whole is 70 V. At this time, the output voltage of the first module 11A is 10 V, the output voltage of the second module 11B is 12 V, and the output voltage of the third module 11C is 14 V. In addition, the output voltage of the fourth module 11D is 16 V, and the output voltage of the fifth module 11E is 18 V.

When a malfunction occurs in one of the 20 cells 12A possessed by the first module 11A, and the first bypass diode 13A is turned on to bypass the first module 11A, a potential difference across the first module 11A becomes 1 V. Thus, the output voltage of the first to fifth modules 11A to 11E as a whole in this case becomes 59 V, and the output voltage is decreased by 11 V from the time of the normal power generation.

When a malfunction occurs in one of the 24 cells 12B possessed by the second module 11B, and the second bypass diode 13B is turned on to bypass the second module 11B, a potential difference across the second module 11B becomes 1 V. Thus, the output voltage of the first to fifth modules 11A to 11E as a whole in this case becomes 57 V, and the output voltage is decreased by 13 V from the time of the normal power generation.

Similarly, when a malfunction occurs in one of the 28 cells 12C possessed by the third module 11C, the total output voltage is decreased by 15 V from the normal time. When a malfunction occurs in one of the 32 cells 12D possessed by the fourth module 11D, the total output voltage is decreased by 17 V from the normal time. When a malfunction occurs in one of the 36 cells 12E possessed by the fifth module 11E, the total output voltage is decreased by 19 V from the normal time.

By thus checking the output voltage of the first to fifth modules 11A to 11E as a whole and referring to the relations of the decreases in the output voltage as shown in FIG. 9, a bypassed one of the first to fifth modules 11A to 11E is identified. Specifically, when the output voltage of the first to fifth modules 11A to 11E as a whole is 59 V, the output voltage is decreased by 11 V from the normal time, and it is thereby determined that the first module 11A is bypassed.

In this case, a user can recognize that a malfunction has occurred in one of the 20 cells 12A included in the first module 11A. The user can further determine whether the malfunction has occurred in the cells 12A possessed by the first module 11A due to an effect of a partial shadow by visually checking the first module 11A. Alternatively, when there is no shadow on the cells 12A, the user can determine whether a failure has occurred in the cells 12A without an effect of a shadow by checking the output voltage of the first to fifth modules 11A to 11E as a whole.

Thus, the photovoltaic power generating system 31-2 enables a bypassed one of the first to fifth modules 11A to 11E to be identified by checking the output voltage of the first to fifth modules 11A to 11E as a whole. Thereby, the user can recognize that a cell 12 in which a malfunction has occurred is included in the bypassed one of the first to fifth modules 11A to 11E, and identify the cell 12 in which the malfunction has occurred to a certain extent.

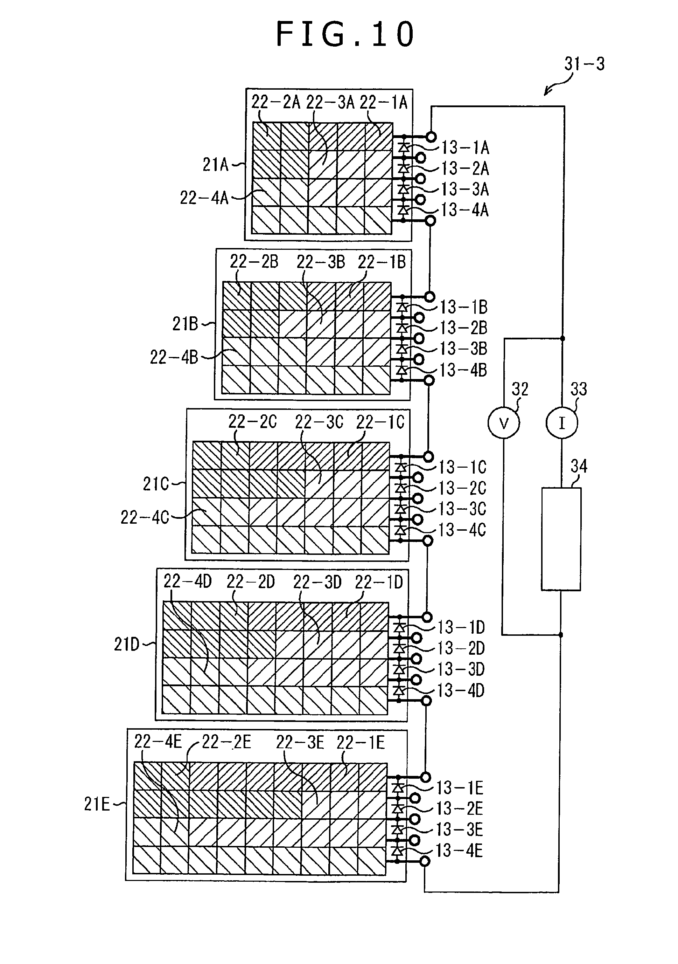

Next, FIG. 10 is a block diagram showing a configuration example of a third embodiment of the photovoltaic power generating system.

As shown in FIG. 10, the photovoltaic power generating system 31-3 includes a first to a fifth module 21A to 21E, a voltage measuring section 32, a current measuring section 33, and a load 34. Incidentally, the voltage measuring section 32, the current measuring section 33, and the load 34 are formed in a same manner as in the photovoltaic power generating system 31-1 of FIG. 6, and therefore detailed description thereof will be omitted.

In the photovoltaic power generating system 31-3, the first to fifth modules 21A to 21E are connected in series with each other, and the first to fifth modules 21A to 21E have respective different numbers of cells 12. Further, the first to fifth modules 21A to 21E are each configured such that a first to a fourth cell group 22-1 to 22-4 are respectively bypassed by a first to a fourth bypass diode 13-1 to 13-4, as in the module 21 of FIG. 3.

For example, the first module 21A is formed by connecting 20 cells 12 in series with each other. In the first module 21A, the 20 cells 12 are divided by a first to a fourth bypass diode 13-1A to 13-4A into four parts, that is, a first cell group 22-1A including three cells 12, a second cell group 22-2A including four cells 12, a third cell group 22-3A including six cells 12, and a fourth cell group 22-4A including seven cells 12.

In addition, the second module 21B is formed by connecting 24 cells 12 in series with each other. In the second module 21B, the 24 cells 12 are divided by a first to a fourth bypass diode 13-1B to 13-4B into four parts, that is, a first cell group 22-1B including three cells 12, a second cell group 22-2B including five cells 12, a third cell group 22-3B including seven cells 12, and a fourth cell group 22-4B including nine cells 12.

Similarly, the third module 21C is formed by connecting 28 cells 12 in series with each other. In the third module 21C, the 28 cells 12 are divided by a first to a fourth bypass diode 13-1C to 13-4C into four parts, that is, a first cell group 22-1C including five cells 12, a second cell group 22-2C including six cells 12, a third cell group 22-3C including eight cells 12, and a fourth cell group 22-4C including nine cells 12.

In addition, the fourth module 21D is formed by connecting 32 cells 12 in series with each other. In the fourth module 21D, the 32 cells 12 are divided by a first to a fourth bypass diode 13-1D to 13-4D into four parts, that is, a first cell group 22-1D including five cells 12, a second cell group 22-2D including seven cells 12, a third cell group 22-3D including nine cells 12, and a fourth cell group 22-4D including 11 cells 12.

In addition, the fifth module 21E is formed by connecting 36 cells 12 in series with each other. In the fifth module 21E, the 36 cells 12 are divided by a first to a fourth bypass diode 13-1E to 13-4E into four parts, that is, a first cell group 22-1E including seven cells 12, a second cell group 22-2E including eight cells 12, a third cell group 22-3E including ten cells 12, and a fourth cell group 22-4E including 11 cells 12.

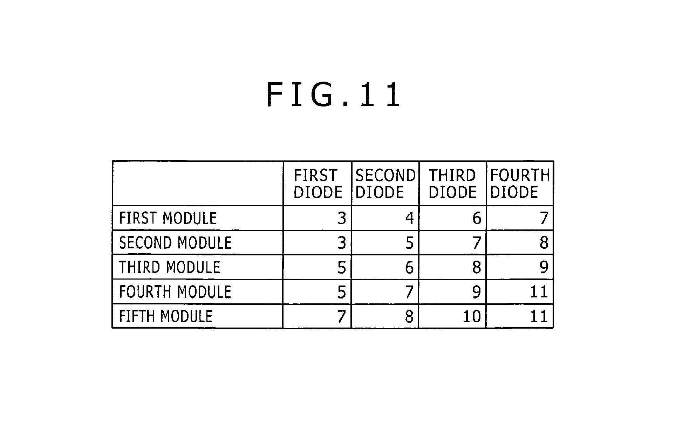

FIG. 11 shows the numbers of cells 12 bypassed by the bypass diodes 13 in each of the first to fifth modules 21A to 21E.

As shown in FIG. 11, in the first module 21A, three cells 12 are bypassed by the first bypass diode 13-1A, and four cells 12 are bypassed by the second bypass diode 13-2A. In addition, six cells 12 are bypassed by the third bypass diode 13-3A, and seven cells 12 are bypassed by the fourth bypass diode 13-4A.

Similarly, in the second module 21B, the third module 21C, the fourth module 21D, and the fifth module 21E, numbers of cells 12 shown in FIG. 11 are bypassed by the respective corresponding bypass diodes 13.

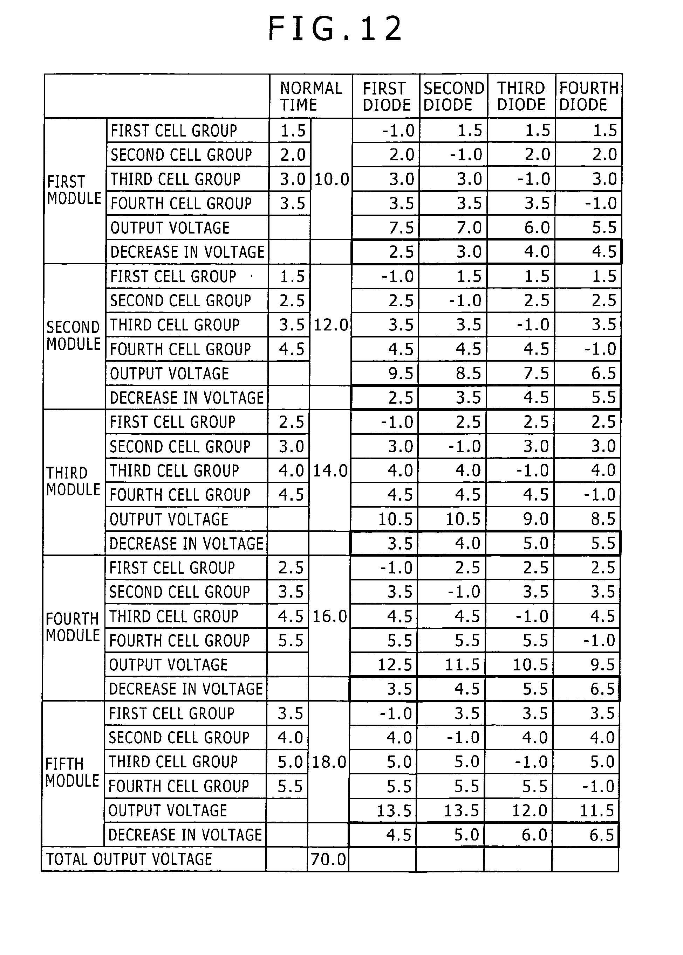

Next, decreases in output voltage when a malfunction occurs in cells 12 in the photovoltaic power generating system 31-3 will be described with reference to FIG. 12.

FIG. 12 shows an example of the output voltage when the voltage generated by one cell 12 is 0.5 V and when the voltage in a forward direction of the first to fourth bypass diodes 13-1A to 13-4E is 1.0 V.

When all of the cells 12 possessed by the photovoltaic power generating system 31-3 generate power normally, the output voltage of the photovoltaic power generating system 31-3 as a whole is 70.0 V. At this time, the output voltage of the first module 21A is 10.0 V, the output voltage of the second module 21B is 12.0 V, and the output voltage of the third module 21C is 14.0 V. In addition, the output voltage of the fourth module 21D is 16.0 V, and the output voltage of the fifth module 21E is 18.0 V.

As for the first module 21A, when the first bypass diode 13-1A is turned on to bypass the first cell group 22-1A, the output voltage is decreased by 2.5 V from the normal time. In addition, when the second bypass diode 13-2A is turned on to bypass the second cell group 22-2A, the output voltage is decreased by 3.0 V from the normal time. Similarly, when the third cell group 22-3A is bypassed by the third bypass diode 13-3A, the output voltage is decreased by 4.0 V from the normal time. In addition, when the fourth cell group 22-4A is bypassed by the fourth bypass diode 13-4A, the output voltage is decreased by 4.5 V from the normal time.

In addition, as for the second module 21B, when the first bypass diode 13-1B is turned on to bypass the first cell group 22-1B, the output voltage is decreased by 2.5 V from the normal time. In addition, when the second bypass diode 13-2B is turned on to bypass the second cell group 22-2B, the output voltage is decreased by 3.5 V from the normal time. Similarly, when the third cell group 22-3B is bypassed by the third bypass diode 13-3B, the output voltage is decreased by 4.5 V from the normal time. In addition, when the fourth cell group 22-4B is bypassed by the fourth bypass diode 13-4B, the output voltage is decreased by 5.5 V from the normal time.

In addition, as for the third module 21C, when the first bypass diode 13-1C is turned on to bypass the first cell group 22-1C, the output voltage is decreased by 3.5 V from the normal time. In addition, when the second bypass diode 13-2C is turned on to bypass the second cell group 22-2C, the output voltage is decreased by 4.0 V from the normal time. Similarly, when the third cell group 22-3C is bypassed by the third bypass diode 13-3C, the output voltage is decreased by 5.0 V from the normal time. In addition, when the fourth cell group 22-4C is bypassed by the fourth bypass diode 13-4C, the output voltage is decreased by 5.5 V from the normal time.

In addition, as for the fourth module 21D, when the first bypass diode 13-1D is turned on to bypass the first cell group 22-1D, the output voltage is decreased by 3.5 V from the normal time. In addition, when the second bypass diode 13-2D is turned on to bypass the second cell group 22-2D, the output voltage is decreased by 4.5 V from the normal time. Similarly, when the third cell group 22-3D is bypassed by the third bypass diode 13-3D, the output voltage is decreased by 5.5 V from the normal time. In addition, when the fourth cell group 22-4D is bypassed by the fourth bypass diode 13-4D, the output voltage is decreased by 6.5 V from the normal time.

In addition, as for the fifth module 21E, when the first bypass diode 13-1E is turned on to bypass the first cell group 22-1E, the output voltage is decreased by 4.5 V from the normal time. In addition, when the second bypass diode 13-2E is turned on to bypass the second cell group 22-2E, the output voltage is decreased by 5.0 V from the normal time. Similarly, when the third cell group 22-3E is bypassed by the third bypass diode 13-3E, the output voltage is decreased by 6.0 V from the normal time. In addition, when the fourth cell group 22-4E is bypassed by the fourth bypass diode 13-4E, the output voltage is decreased by 6.5 V from the normal time.

Thus, by checking the output voltage of the first to fifth modules 21A to 21E as a whole and referring to the relations of the decreases in the output voltage as shown in FIG. 12, a bypassed cell group 22 is identified.

Specifically, when the output voltage of the first to fifth modules 21A to 21E as a whole is 67.5 V, the output voltage is decreased by 2.5 V from the normal time, and it is thereby determined that the first cell group 22-1A in the first module 21A or the first cell group 22-1B in the second module 21B is bypassed. Similarly, for example, when the output voltage of the first to fifth modules 21A to 21E as a whole is 64.0 V, the output voltage is decreased by 6.0 V from the normal time, and it is thereby determined that the third cell group 22-3E in the fifth module 21E is bypassed.

As described above, the photovoltaic power generating system 31-3 enables a bypassed cell group 22 to be identified when a malfunction has occurred in one of the cells 12 by checking the output voltage of the first to fifth modules 21A to 21E as a whole. Thereby, the cell 12 in which the malfunction has occurred can be identified to a certain extent.

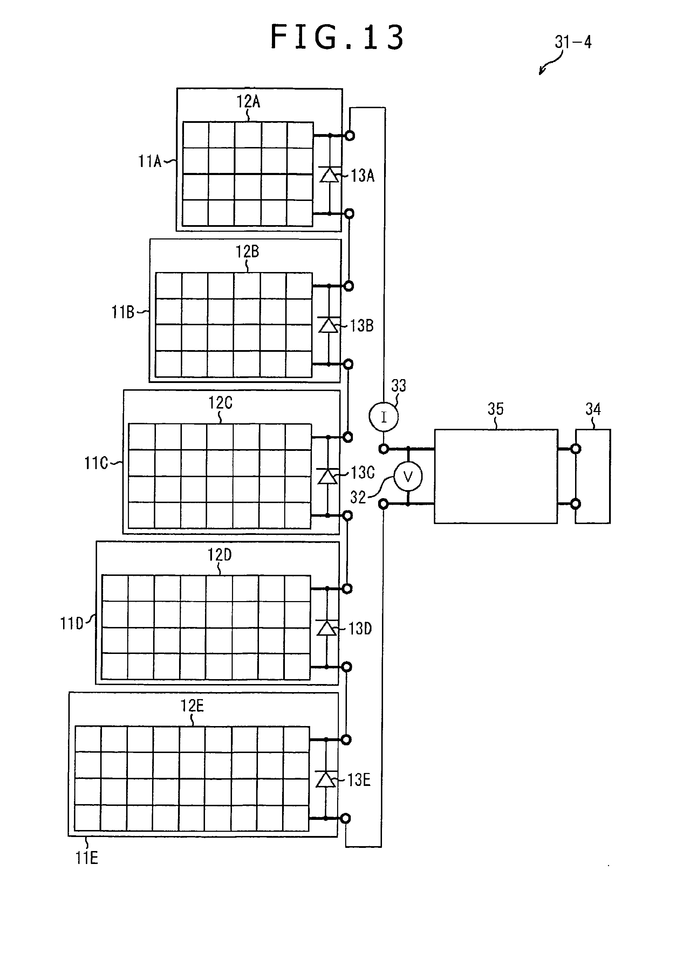

Next, FIG. 13 is a block diagram showing a configuration example of a fourth embodiment of the photovoltaic power generating system.

As shown in FIG. 13, the photovoltaic power generating system 31-4 includes a first to a fifth module 11A to 11E, a voltage measuring section 32, a current measuring section 33, a load 34, and a system box 35. Incidentally, the first to fifth modules 11A to 11E, the voltage measuring section 32, the current measuring section 33, and the load 34 are formed in a same manner as in the photovoltaic power generating system 31-2 of FIG. 8, and therefore detailed description thereof will be omitted.

The system box 35 is connected between the first to fifth modules 11A to 11E and the load 34. The system box 35 for example has the functions of a power conditioner that adjusts power generated by the first to fifth modules 11A to 11E so that the power can be used in the load 34.

The system box 35 also has a function of controlling power generation efficiency on the basis of the power generation characteristics of the first to fifth modules 11A to 11E as a whole.

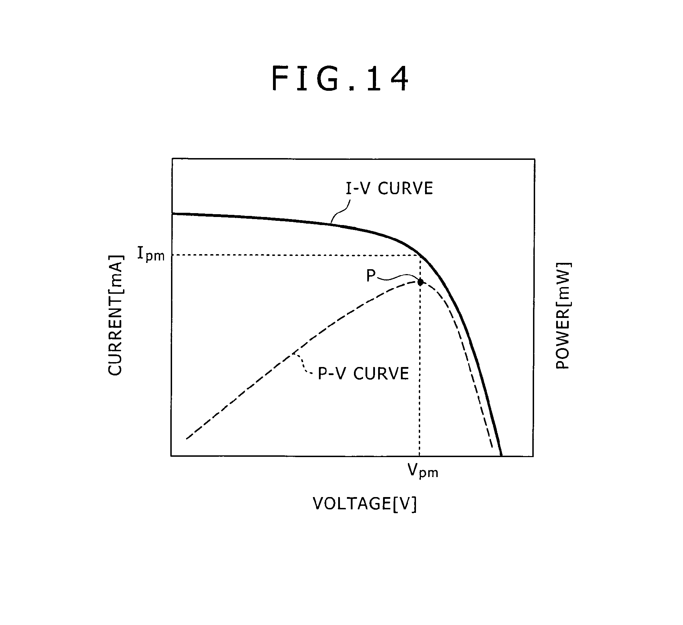

For example, FIG. 14 shows the power generation characteristics of the first to fifth modules 11A to 11E as a whole.

In FIG. 14, an axis of abscissas indicates voltage, and an axis of ordinates on a left side indicates current. A curve (I-V curve) represented by a solid line in FIG. 14 shows the characteristics of the voltage and current of power output from the first to fifth modules 11A to 11E. In addition, an axis of ordinates on a right side in FIG. 14 indicates power. A curve (P-V curve) represented by a broken line in FIG. 14 shows the characteristic of the power output from the first to fifth modules 11A to 11E.

For example, the system box 35 performs MPPT (Maximum Power Point Tracker) control that tracks a maximum output point P according to variations in the power generation characteristics of the first to fifth modules 11A to 11E as a whole, variations in the power used by the load 34, and the like. That is, the system box 35 controls the first to fifth modules 11A to 11E so that the power of a current Ipm such as gives a voltage Vpm enabling power to be output at the maximum output point P is output from the first to fifth modules 11A to 11E.

The system box 35 also has a function of identifying a cell 12 in which a malfunction has occurred more accurately.

In this case, because whether the first to fifth bypass diodes 13A to 13E are operating or not is an important item as a precondition for identifying a cell 12 in which a malfunction has occurred, it may be essential that measurement be performed in a state of a current flowing in the photovoltaic power generating system 31-4. That is, a cell 12 in which a malfunction has occurred may not be identified on the basis of measurement with open-circuit voltage or short-circuit current.

Specifically, it is desirable to set a voltage serving as a reference in the MPPT control (voltage Vpm in FIG. 14), and perform measurement using the voltage Vpm as a reference. While the first to fifth modules 11A to 11E exhibit the power generation characteristics as shown in FIG. 14, the characteristics vary according to an amount of light with which the first to fifth modules 11A to 11E are irradiated. That is, the voltage Vpm changes.

Accordingly, the power generation characteristics of the first to fifth modules 11A to 11E at a specific amount of light irradiation (power generation characteristics as shown in FIG. 14) are obtained in advance, and the power generation characteristics are stored in the system box 35. The system box 35 can identify a cell 12 in which a malfunction has occurred more accurately by sampling a voltage value measured by the voltage measuring section 32 in predetermined timing and comparing the voltage value with the power generation characteristics obtained in advance.

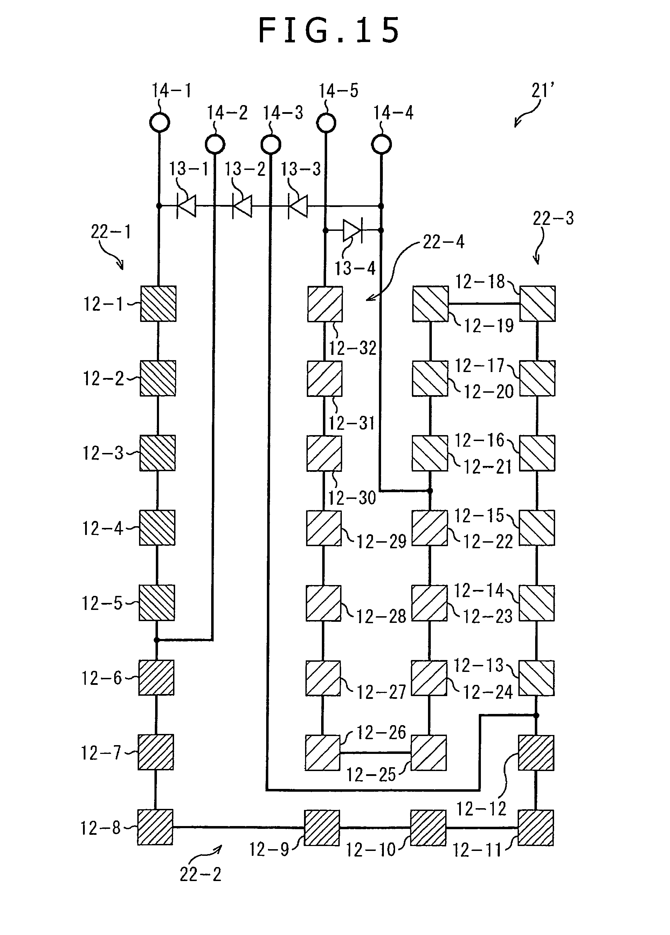

Next, FIG. 15 is a diagram showing a modification example of the module 21.

As shown in FIG. 15, as with the module 21 of FIG. 3, a module 21' includes cells 12-1 to 12-32 and a first to a fourth bypass diode 13-1 to 13-4. In addition, in the module 21', the cells 12-1 to 12-32 are arranged so as to form an eight-by-four array, as in the module 21 of FIG. 5. However, the arrangement of a first to a fourth cell group 22-1 to 22-4 of the module 21' is different from that of the module 21 of FIG. 5.

It is generally considered that an effect of a partial shadow on the module 21' starts from a peripheral part of the module 21', and does not suddenly start from a central part of the module 21'. The module 21' hence has an arrangement such that the fourth cell group 22-4 including many cells 12 forms the central part and the first to third cell groups 22-1 to 22-3 including smaller numbers of cells 12 than the fourth cell group 22-4 form the peripheral part.

With such an arrangement, in the module 21', the first to third cell groups 22-1 to 22-3 including smaller numbers of cells 12 than the fourth cell group 22-4 are more affected by a partial shadow. That is, the fourth cell group 22-4 disposed in the central part of the module 21' can be prevented from being affected by a partial shadow easily.

Thus, as compared with the constitution having the fourth cell group 22-4 disposed in the peripheral part, the module 21' can decrease a rate at which the output of the module 21' is reduced greatly. The module 21' can thereby minimize a loss in total power generated.

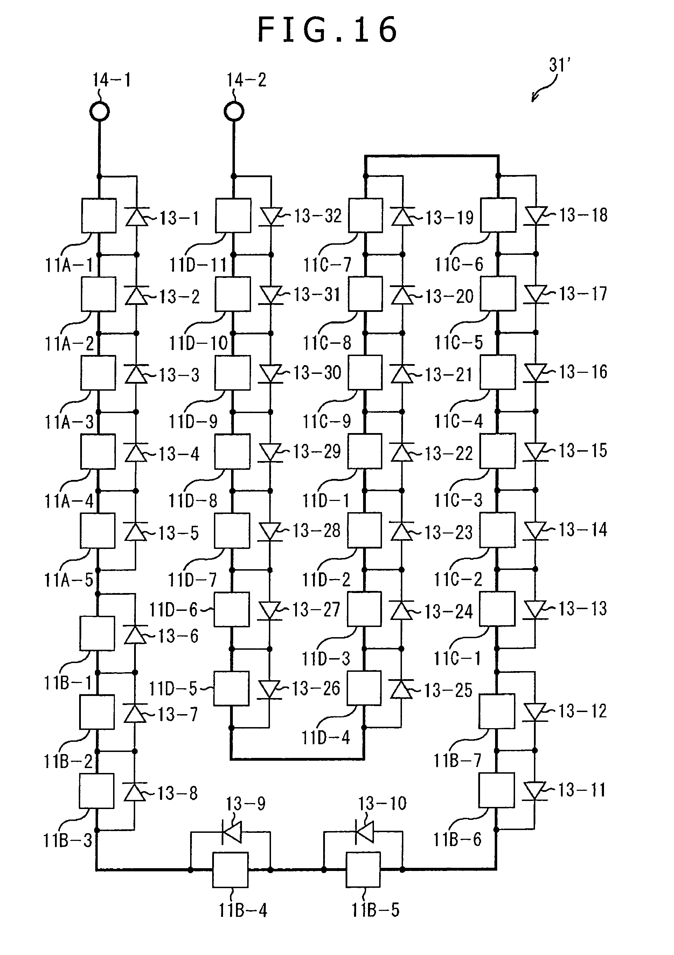

Next, FIG. 16 is a diagram showing a modification example of the photovoltaic power generating system 31.

As shown in FIG. 16, a photovoltaic power generating system 31' includes modules 11A-1 to 11A-5, modules 11B-1 to 11B-7, modules 11C-1 to 11C-9, and modules 11D-1 to 11D-11. Incidentally, FIG. 16 does not show a voltage measuring section 32, a current measuring section 33, and a load 34.

The modules 11A-1 to 11A-5 each have 20 cells 12A connected in series with each other, as with the first module 11A in FIG. 8. Bypass diodes 13-1 to 13-5 are provided so as to connect both ends of the modules 11A-1 to 11A-5 to each other, respectively. In addition, the modules 11B-1 to 11B-7 each have 24 cells 12B connected in series with each other, as with the second module 11B in FIG. 8. Bypass diodes 13-6 to 13-12 are provided so as to connect both ends of the modules 11B-1 to 11B-7 to each other, respectively.

Similarly, modules 11C-1 to 11C-9 each have 28 cells 12C connected in series with each other, as with the third module 11C in FIG. 8. Bypass diodes 13-13 to 13-21 are provided so as to connect both ends of the modules 11C-1 to 11C-9 to each other, respectively. In addition, the modules 11D-1 to 11D-11 each have 32 cells 12D connected in series with each other, as with the fourth module 11D in FIG. 8. Bypass diodes 13-22 to 13-32 are provided so as to connect both ends of the modules 11D-1 to 11D-11 to each other, respectively.

The photovoltaic power generating system 31' has an arrangement such that the modules 11D-1 to 11D-11 including many cells 12 form a central part and the modules 11A-1 to 11C-6 including smaller numbers of cells 12 than the modules 11D-1 to 11D-11 form a peripheral part.

Thereby, in the photovoltaic power generating system 31', as in the module 21' described with reference to FIG. 15, the modules 11D-1 to 11D-11 arranged in the central part are prevented from being affected by a partial shadow easily. Thus, the photovoltaic power generating system 31' can minimize a loss in total power generated.

Incidentally, in the present specification, a system refers to an apparatus as a whole formed by a plurality of devices.

It is to be noted that embodiments of the present technology are not limited to the foregoing embodiments, and that various changes can be made within the scope of the claims.

The present disclosure contains subject matter related to that disclosed in Japanese Priority Patent Application JP 2011-001953 filed in the Japan Patent Office on January 7, 2011, the entire content of which is hereby incorporated by reference.

## Claims

1. A photovoltaic power generating module comprising:
a cell configured to generate power according to light received by the cell;
a plurality of cell groups formed by connecting a predetermined number of said cells in series with each other; and
a plurality of bypass sections configured to bypass the respective said cell groups connected in series with each other;
wherein said cell groups are formed by respective different numbers of said cells.

2. The photovoltaic power generating module according to claim 1,
wherein said cell group including a small number of said cells is disposed in a peripheral part.

3. A photovoltaic power generating system comprising:
a cell configured to generate power according to light received by the cell;
a plurality of photovoltaic power generating modules formed by connecting a predetermined number of said cells in series with each other; and
a plurality of bypass sections configured to bypass the respective said photovoltaic power generating modules connected in series with each other;
wherein said photovoltaic power generating modules have respective different numbers of said cells.

4. The photovoltaic power generating system according to claim 3,
wherein a plurality of said cells possessed by said photovoltaic power generating modules are divided into cell groups formed by connecting a predetermined number of said cells in series with each other,
a plurality of said bypass sections are disposed so as to bypass the respective said cell groups, and
said cell groups in at least said identical photovoltaic power generating module are formed by respective different numbers of said cells.

5. The photovoltaic power generating system according to claim 3 or 4,
wherein said photovoltaic power generating module including a small number of said cells is disposed in a peripheral part.
